# EUROPEAN PATENT SPECIFICATION

(11) **EP 1 519 425 B1**
(45) Date of publication and mention of the grant of the patent: **21.06.2006**
(21) Application number: 04255835.3
(22) Date of filing: 24.09.2004
(51) Int. Cl.: H01L 41/047, H01L 41/083, H01L 41/22

(54) **Piezoelectric actuator device**
Piezoelektrischer Aktor
Actionneur piézoélectrique

(30) Priority: 25.09.2003 EP 03256046
(43) Date of publication of application: 30.03.2005
(73) Proprietor: Delphi Technologies, Inc., Troy, MI 48007 (US)
(72) Inventor: Cooke, Michael, Gillingham Kent ME7 1DR (GB); Goat, Christopher, Offham Kent ME19 5NU (GB); Sfakianakis, Stavros, Gillingham Kent ME7 5SD (GB)
(74) Representative: Hopley, Joanne Selina

(56) References cited:
- US-A- 2 861 320
- US-A- 4 471 256
- PATENT ABSTRACTS OF JAPAN vol. 014, no. 467 (E-0989), 11 October 1990 (1990-10-11) -& JP 02 192186 A (TOTO LTD), 27 July 1990 (1990-07-27)
- R. M. MORTON ET AL: "High Performance AC Chip Contactor" IBM TECHNICAL DISCLOSURE BULLETIN, vol. 18, no. 3, 1 August 1975 (1975-08-01), pages 749-750, XP002314942 New York, US

## Description

The invention relates to a piezoelectric actuator device, more particularly but not exclusively a piezoelectric device suitable for use in fuel injectors of internal combustion engines.

Known piezoelectric fuel injectors typically employ piezoelectric actuators having a stack of piezoelectric elements arranged mechanically in series for opening and closing an injection valve to meter fuel injected into the engine. It is known to locate the piezoelectric actuator in a chamber containing fuel at injection pressures to control movement of a valve needle either by mechanical or hydraulic coupling. An example of a piezoelectric fuel injector is disclosed in U.S. Patent No. 6520423. For such applications in particular, known piezoelectric actuator devices have several limitations.

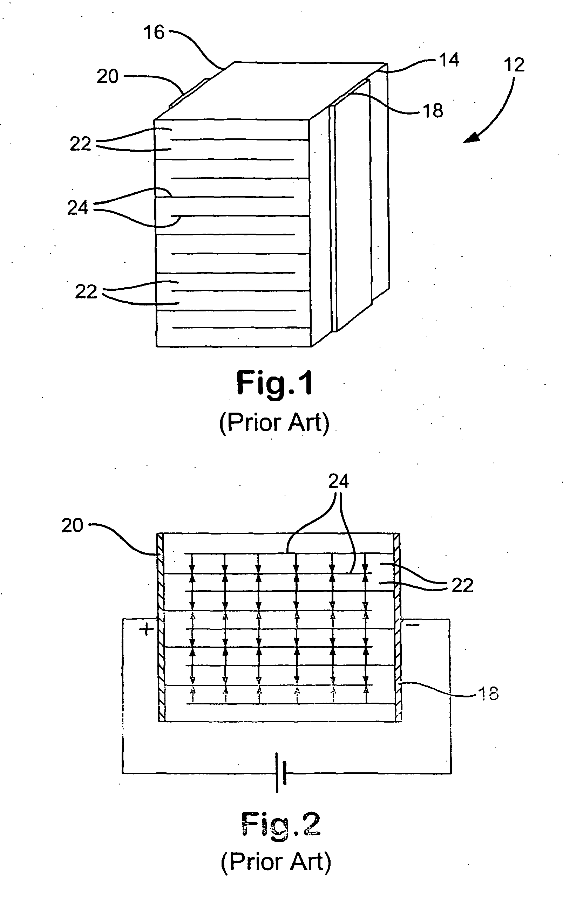

A typical multi-layer actuator or stack is shown in Figure 1 and comprises a generally rectangular stack body 12 having first and second opposing outer surfaces 14, 16 and associated first and second external conductors 18, 20. The body 12 comprises a plurality of relatively thin piezoelectric elements or layers 22, each of which is spaced from adjacent elements 22 by an internal electrode 24. Alternate ones of the internal electrodes 24 are electrically connected to the first external conductor 18 and second external conductor 20 respectively to comprise two groups of electrodes, whereby the electrodes of one group are interdigitated with the electrodes of the other group.

With reference to Figure 2, a voltage is applied across the two external conductors 18, 20 whereby an adjacent pair of internal electrodes 24 sandwiching a piezoelectric element 22 become mutual conductors of opposite polarity and apply an electric field to said element 22. Since each element has a typical thickness of around 100 µm, a sufficient electric field strength of, for example 2kV/mm, can be attained between the electrodes 24 by way of an applied voltage of 200V. Due to the alternating polarity of the electric fields generated between the internal electrodes 24, the poling direction of the elements 22 also alternates throughout the structure of the actuator.

Although existing multi-layer piezoelectric actuators succeed in lowering the required operational voltages, they have several associated problems that will now be discussed.

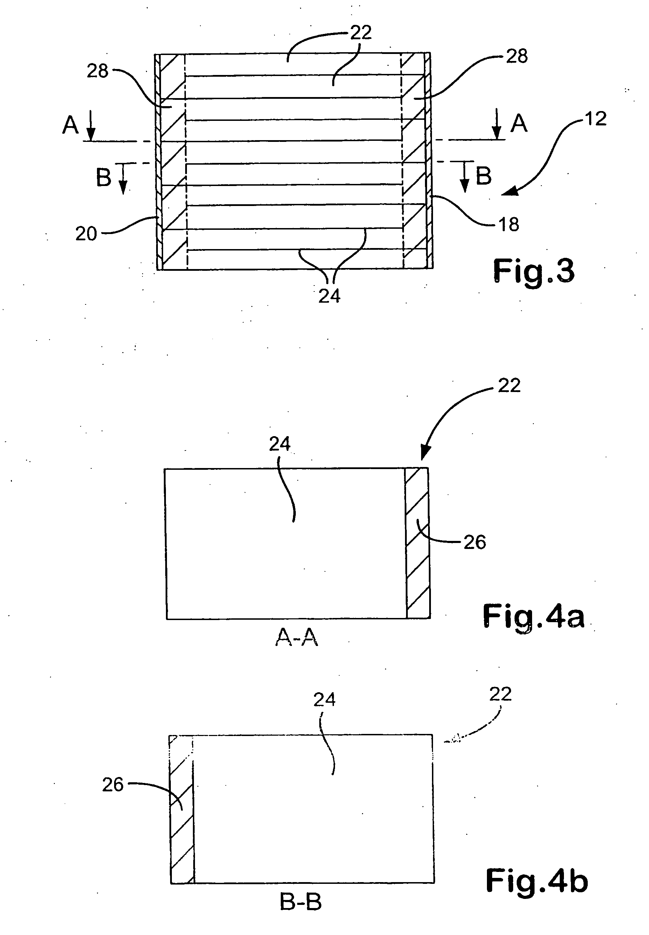

Electrical insulation between an external conductor and an internal electrode of opposite polarity must be ensured to enable an electric field to be established in the sandwiched material. Isolation of the two electrode groups is usually achieved by terminating each electrode of a respective group short of the opposite polarity conductor. As can be seen from Figures 3, 4a and 4b, each piezoelectric element 22 is coated with an electrode 24 over at least a part of its surface leaving a margin 26 where the element 22 is uncoated. When formed into a stack 12, the margins 26 of adjacent elements 22 are located on opposing sides of the stack 12 and create "in-active zones" 28 in the multi-layered stack 12 that will not be exposed to an electric field during operation. It is desirable to minimise the size of the inactive zones 28 since the energy provided by the electric field to each element 22 is partially dissipated by the inactive zones 28, thus, the maximum stroke of the stack 12 increases with a greater active area. However, a margin 26 must necessarily be maintained between the terminated edge of an internal electrode 24 of a first polarity and an external electrode 18, 20 of opposite polarity to avoid a short circuit.

Additionally, since only the material subject to an applied electric field undergoes piezoelectric strain, a strain discontinuity arises at the interface between the active and inactive areas which may lead to cracks forming at, and propagating away from, the terminated ends of the interdigitated electrodes 24. The cracks may affect the structural integrity of the actuator and reduce its reliability and operational life. Furthermore, it is necessary to control the dimensions of the margins 26 during manufacture since unequal margins 26 may lead to asymmetry of inactive zones 28 on opposing sides of the stack 12, causing bending moments and thus further stressing the stack 12 during operation.

Cracks may also propagate inwardly from the point of contact between the internal electrodes 24 and the external current conducting elements 28, 20. This arises as the material is weakened by micro-cracking caused by the alloying effects of the compositions of the internal electrodes and the external conducting elements 18, 20 during manufacture.

Common to actuators of the type described is the need to connect the side-mounted conductors 18, 20 to a power supply and difficulties arise in achieving adequate electrical connection whilst maintaining sufficient insulation of the entire stack 12. In addition, some form of electrical connector must be accommodated by the injector assembly reducing both the space available for the actuator itself and increasing the complexity and hence cost of the assembly as a whole.

As background to the present invention, US 4,471,256 describes a piezoelectric actuator comprising of a lamination of piezoelectric plates to which a voltage is applied, in use. The piezoelectric actuator includes two longitudinal openings through which a respective electrode rod extends. The electrode rods serve to distribute charge to the electrode layers within the piezoelectric actuator.

JP2192186 describes a piezoelectric actuator comprising laminated piezoelectric elements, each element having a conductive layer applied on each side of the element. Two longitudinal bores extend through the actuator, each bore receiving a conducting pin. The conducting pins serve to distribute charge to the conductive layers between each piezoelectric element.

It is an object of the present invention to provide a piezoelectric actuator device which substantially avoids or at least alleviates some of the aforementioned problems and further, to reduce the manufacturing complexity and hence cost of such a device.

According to the present invention, there is provided a piezoelectric actuator device including a stack of one or more piezoelectric elements defining an external stack boundary and means for applying a voltage across the one or more piezoelectric elements, wherein the means includes a pair of opposing electrodes, first and second channels disposed inward of the external stack boundary and positive and negative conductor members received by said first and second channels respectively. The conductor members comprise a material that is of liquid behaviour during at least a period of actuator operation.

The material of the conductor members may be selected to be one that becomes liquid at the operating temperature of the actuator (typically between 100°C and 150°C, or thereabouts).

Alternatively, the material of the conductor members may be selected to be one which is of liquid behaviour at room temperature.

The positive and negative conductor members are received by the first and second channels respectively, so as to make contact with the opposing electrode pair.

Preferably, the stack comprises a plurality of piezoelectric elements wherein adjacent elements share a common electrode and the first and second channels are defined by apertures in the piezoelectric elements and corresponding electrodes.

The piezoelectric actuator device has particular benefit when employed in a fuel injector. Since the conductor members are located inside the stack, they are protected from a high pressure and moisture-bearing environment which avoids corrosion and undue stress of the conductor members. Furthermore, since the conductor members are able to exhibit liquid behaviour during at least a period of actuator operation, problems due to metal fatigue occurring at the electrical and mechanical interface between the electrodes and conductor members are avoided. In addition, the difficulties associated with insulating a stack having external conductors can be avoided.

Preferably, the apertures of a first group of alternate ones of the electrodes are shaped so as to be in electrical contact with the positive conductor member and the apertures of a second group of remaining alternate ones of the electrodes are shaped so as to be in electrical contact with the negative conductor member. Therefore, an electric field is generated in each piezoelectric element, the polarity of which alternates between successive elements.

Still preferably, the electrodes of each pair are planar and mutually parallel, and the conductor members intersect the electrodes substantially perpendicular to the plane of the electrodes.

Arranging the conductor members within the external stack boundary (that is to say internal to the stack) in this manner avoids inactive zones being located on opposing faces of the stack as is common in the prior art. Consequently, the effects of the inactive zones "clamping" the active zones, for instance, cracking in the elements and bending of the stack, can be largely prevented.

Whilst it is envisaged that the apertures (hence the channels) may be substantially circular, they may alternatively be polygonal (e.g. square or rectangular). Similarly, although the apertures are preferably disposed on an axis of symmetry of an electrode, they may also be disposed offset from said axis. This allows design freedom in the design of a piezoelectric device in accordance with the invention.

The invention will now be described, by way of example only, with reference to the accompanying drawings in which:
Figure 1 is a perspective view of a known piezoelectric actuator device;
Figure 2 is a schematic side view of the piezoelectric actuator device of Figure 1;
Figure 3 is a side view of the piezoelectric actuator device in Figure 1;
Figures 4a and 4b are sectional views of the piezoelectric actuator device in Figure 3 through the lines A-A and B-B showing two consecutive internal electrode layers;
Figure 5 is a section view of another piezoelectric actuator device;
Figure 6 is an enlarged side view of the piezoelectric actuator device in Figure 5;
Figures 7a and 7b are sectional views of the piezoelectric actuator device in Figure 6 though the lines A-A and B-B showing two successive internal electrode layers;
Figure 8 is an enlarged side view of a piezoelectric actuator device of an embodiment of the present invention, and;
Figure 9 is an enlarged side view of a piezoelectric actuator device of a further alternative embodiment of the present invention.

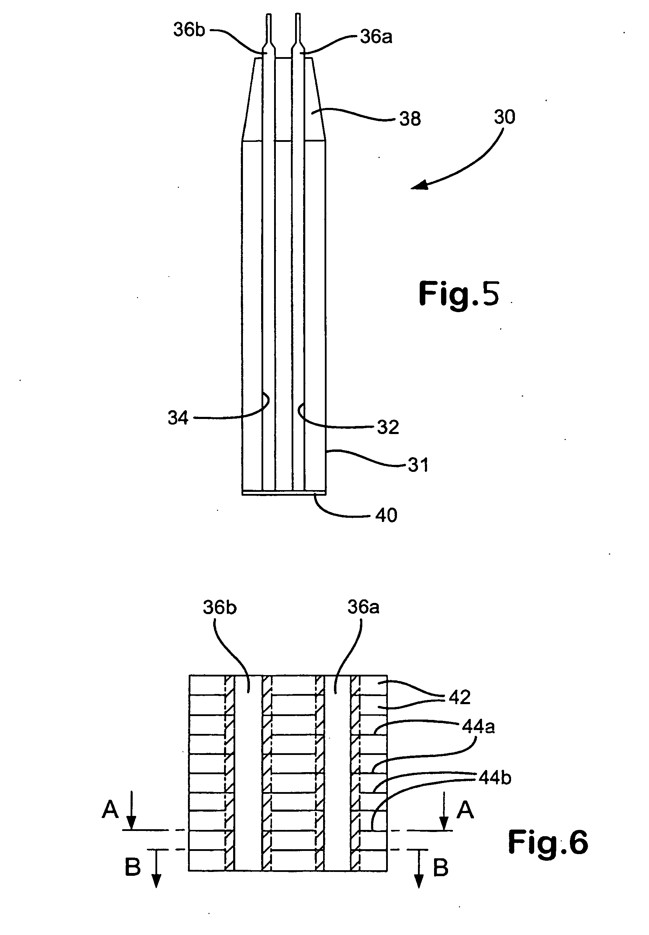

Referring firstly to Figures 5 and 6, there is shown a piezoelectric actuator device 30 having a stack 31 of piezoelectric elements defining a stack boundary and being provided with first and second longitudinal channels or passages 32, 34 disposed inwardly of the stack boundary for receiving conductor means. The conductor means include rod-like conducting members 36a, 36b each of which extends through a respective one of the channels 32, 34. The stack 31 comprises a first end piece 38 and a second end piece 40 and a plurality of piezoelectric elements or layers 42, adjacent elements 42 being spaced apart by internal electrodes 44a, 44b, which are arranged to be substantially parallel to the first and second end pieces 38, 40 of the device 30. The first end piece 38 is in the form of a cap and the second end piece 40 is in the form of a plate or tile. Alternate ones of the electrodes 44a, 44b form a first group of electrodes and the remaining alternate ones of the electrodes form a second group of electrodes, whereby the electrodes 44a of the first group are in electrical connection with the first conductor member 36a and the electrodes 44b of the second electrode group are in electrical connection with the second internal conductor member 36b. The first and second end pieces 38, 40 are disposed at the ends of the stack 31 and enclose the conductor members 36a, 36b inside the stack 31, and so seal the stack 31, against high pressure fuel for example.

The conductor members 36a, 36b extend along the length of the stack 31 and protrude through the first end piece 38 wherein the ends of the conductors 36a, 36b are adapted for attachment to a suitable electrical connector (not shown). In this embodiment, the first and second pieces 38, 40 are formed from the same material as the piezoelectric elements 42 and become an integral part of the stack 31 following manufacture. The pieces 38, 40 thus provide support to the stack so that the stack may withstand high pressures. However, it will be appreciated that another ceramic composition or indeed any other material appropriate to effect sealing of the stack may alternatively be used, for example, aluminium.

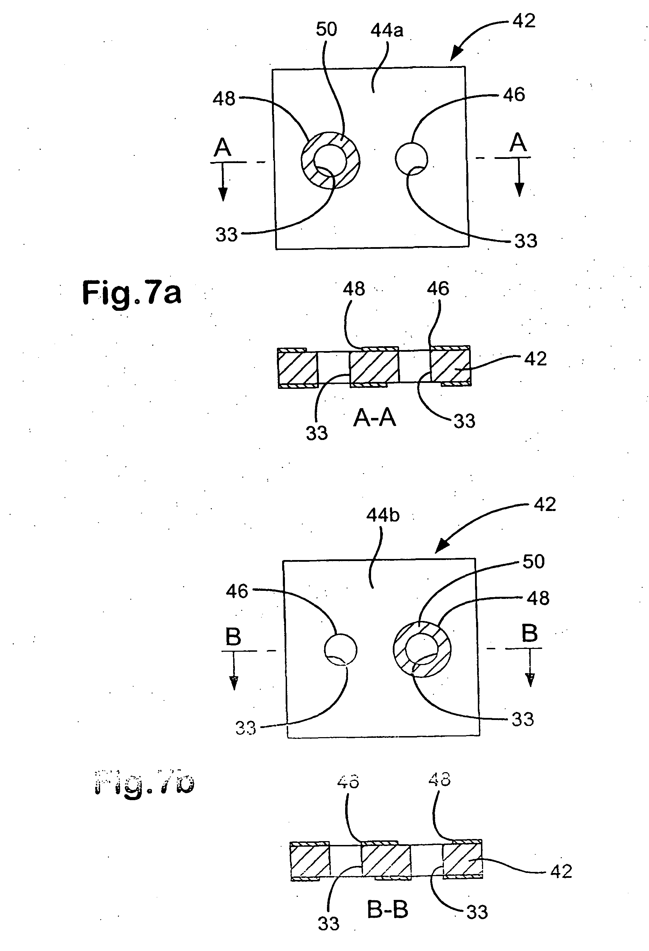

Referring to Figures 7a and 7b, for each piezoelectric element, the internal electrode layers 44a, 44b extend to the edges of the element 42 and are provided with a first generally circular aperture 48 of relatively large diameter and a second generally circular aperture 46 of smaller diameter. Each piezoelectric element 42 is also provided with first and second apertures or openings 33. The piezoelectric element 42 and its associated electrodes 44a, 44b are arranged so that the first, larger aperture 48 in the electrode 44a, 44b aligns with one of the openings 33 in the element 42 and the second, smaller aperture 46 aligns with the other opening 33 in the element 42, so when formed into a stack 31 of elements 42, the aligned openings 33 and apertures 46, 48 define respective first and second channels 32, 34 which are substantially disposed on a symmetrical axis of the elements 42. The small aperture 46 has a diameter substantially equal to the opening 33 and so an electrical connection is formed between the electrode 44a, 44b and the conductor (not shown). Conversely, the second conductor (not shown) is isolated from the electrode layer 44a since the aperture 48 has a larger diameter (and therefore larger area) than the opening 33. It will be appreciated that successive electrode layers in the stack are oriented at 180 degrees to one another (e.g. referring to Figures 7a and 7b which show successive layers). In use, a voltage is applied across the conductors 36a, 36b so that they are of positive and negative polarity and therefore, an inactive zone 50 (also shown in Figure 6) surrounds each internal conductor 36a, 36b. In contrast, prior art multi-layer devices as exemplified in Figures 1 to 3, have an electrode layer 24 printed over a portion of the adjacent piezoelectric element 22 whilst leaving an inactive zone 26 at an edge of the piezoelectric element 22.

In the above-described arrangement, the size of the inactive region is significantly reduced, as compared to known prior art devices, whilst the main advantage of low applied voltages associated with existing multi-layered stacks is maintained. Instead of an inactive zone being located on opposing surfaces of the stack 31 and clamping the active zone, relatively small inactive zones 50 are formed internal to the stack and located around either one of the conductor members 36a, 36b. This reduces the likelihood of cracking between the terminated ends of the internal electrodes.

As well as reducing the size of the inactive regions, the piezoelectric device 30 of the present invention avoids the need for components such as conductors to be attached to the external surface of the stack 31, thus eliminating the manufacturing step required to affix the conductors.

A further advantage with the above arrangement is that the shape of the piezoelectric device is not constrained by the necessity to apply external conductors to faces of the device, so the shape of the device may be designed to suit a specific application. For instance, the stack 31 may be circular or even polygonal in cross section to make efficient use of space within an injector chamber of a fuel injector. Another disadvantage of existing fuel injector designs is that the external conductors (i.e. 18, 20 in Figure 1) also require insulation from a moisture-bearing environment to prevent chemical attack. In practice, forming an effective insulating layer over the stack and the attached components can be difficult to achieve and the insulating material may be forced into any cracks or pits on the surface of the stack by high pressure fuel. This may lead to internal shorting as the cracks are driven across the active region.

With reference to Figure 7a and 7b, although the apertures are disposed in alignment on a lateral axis of the element 42 within the stack 31, the apertures may also be disposed offset from the axis to provide further design freedom for a specific application.

The piezoelectric elements or layers 42 in the device of the present invention may be fabricated by the so-called "green sheet" method, as is well known in the art. The composition of the layers may be constituted by a ferroelectric ceramic of the lead zirconate titanate (PZT) group although it will be appreciated that piezoelectric ceramics of other compositions may also be used. A ceramic sheet (green sheet) is fabricated comprising a plurality of ceramic layers and internal electrode sheets are then screen printed, using a printing mask to form the apertures 46, 48 onto its surface. The internal electrodes 44a, 44b are preferably an alloy of silver and palladium, although any other conductive material such as copper or nickel or any alloy thereof may be used as an alternative. It will be appreciated that the positioning of the printing mask must be controlled accurately so that the apertures in the electrode layers align with one another when formed into a stack to avoid a short circuit between electrodes and conductors of opposite polarity. Successive piezoelectric and electrode layers are alternately laminated until the required stack thickness is reached. The laminate is then formed into an integral monolithic block by sintering. The internal channels 32, 34 of the stack 31 are formed by core-drilling, micro-laser VIA drilling or any appropriate method, and the conductor members 36a, 36b are then inserted into their respective channels. The monolith is then diced into individual samples. It will be appreciated that although the channel formation and conductor member insertion steps may be more readily performed on a monolithic block, they could alternatively be performed on individual samples following dicing of the monolith. Still alternatively, the apertures 33 may be formed in the piezoelectric elements 42 before or after the electrodes are screen-printed.

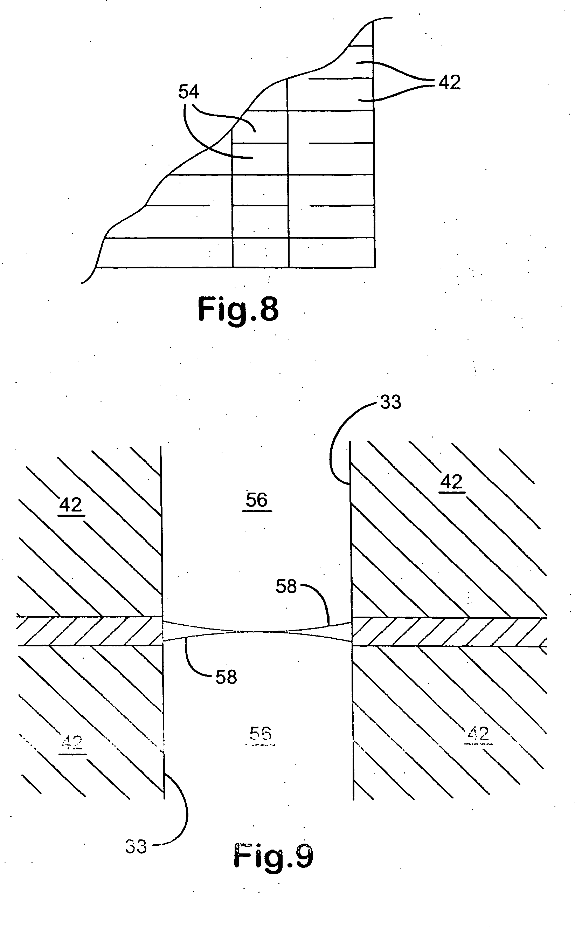

An alternative stack actuator arrangement is shown in Figure 8 and is similar to that as described with reference to Figures 5 to 7, except that the conductors 36a, 36b are formed of a plurality of segments 54 disposed end to end (each segment associated with a piezoelectric element 42). When the piezoelectric elements 42 are stacked to form a stack 31, the conductor segments 54 will, in effect, create a single conductor member, equivalent to 36a, 36b in Figures 5 and 6. A segment 54 can be accommodated by an opening 33 in the piezoelectric element 42 prior to assembly of the stack 31, which may be a more convenient means of manufacture as opposed to inserting a conductor member into a drilled channel of a stack 31.

It is important in this arrangement that extension and contraction of each element 42 due to the applied electric field does not cause relative movement between the conductor segments 54, so that electrical contact between the segments is broken. However, thermal expansion of the segments 54 at operating temperatures may ensure electrical contact between the segments 54 is maintained at all times. Electrical disconnection of the segments 54 can also be avoided by a further arrangement, as shown in Figure 9, in which the conductor segments 56 include domed or convex end faces 58 to compensate for the relative movement between segments 56 and so maintain electrical connection during extension and contraction of the stack. The segments 54, 56 in the above arrangements made be composed of Invar® , platinum or titanium for example.

In existing configurations of piezoelectric actuator devices, external electrodes of solid form generally are favoured since they are convenient to apply to a stack of piezeoelectric elements. However, it has been observed that expansion and contraction of a piezoelectric stack, relative to the external electrodes, can cause stress fractures and cracking therein. As a result, actuator reliability is reduced (reduced mean time between failure). This specific problem is addressed in a further alternative actuator arrangement, in which the conductors 36a, 36b comprise a material that is substantially non-solid during at least a part of injector operation. For the purposes of this specification, the term non-solid is to be taken to mean a material that exhibits liquid behaviour, for example that it does not have a fixed shaped and is capable of flowing (i.e. has flow-like properties). Such a material may comprise an electrically conductive paste, powder or liquid. In a particularly preferred embodiment (not shown), the conductor members (36a, 36b) comprise a fusible alloy having a low melting point e.g. an alloy containing cadmium, gallium or bismuth. Such a material may substantially liquefy during at least a period of actuator operation, for example, when the piezoelectric actuator device reaches its operating temperature (typically 100°C to 150°C). Also, it should be understood that instead of the conducting material becoming liquid at operating temperature, it is feasible for the conducting material to be liquid at non-operating or room temperature, for example mercury. In this case, the material will exhibit liquid behaviour during the whole period of actuator operation.

It will be appreciated that stresses at the electrical interface between the conductors 36a, 36b and the electrode layers 44a, 44b during extension and contraction of the stack will be reduced in this arrangement such that cracks cannot start, let alone propagate, through the conductor members. Similarly, if the conductor members are able to liquefy periodically during part of actuator operation, should cracking begin, the extent of cracking will be interrupted before actuator operation is affected.

In terms of manufacture, following the formation of the internal channels 32, 34 as described above, the paste, powder, or liquid may be injected directly into the internal channels 32, 34. Electrical connection to the conductor material from the power supply (not shown) is achieved by respective conductor pins (not shown) formed in the first end piece 38 and which extend into the channels 32, 34.

In yet another actuator arrangement, the conductors 36a, 36b may be tubular more readily to comply with thermal expansion and irregularities of the channels 32, 34. Furthermore, the first and second end pieces 38, 40 may alternatively be formed of aluminium, for example, to impart additional strength to the stack.

## Claims

1. A piezoelectric actuator device (30) including a stack (31) of one or more piezoelectric elements (42) defining an external stack boundary and means for applying a voltage across the one or more piezoelectric elements (42), wherein the means includes:
a pair of opposing electrodes (44a, 44b);
first and second channels (32, 34) disposed inward of the external stack boundary;
positive and negative conductor members (36a, 36b) received by said first and second channels (32, 34) respectively;
**characterised in that** the conductor members comprise a material that is of liquid behaviour during at least a period of actuator operation.

2. The piezoelectric actuator device (30) as claimed in Claim 1, wherein the material of the conductor members is one which becomes liquid at the operating temperature of the actuator, in use.

3. The piezoelectric actuator device (30) as claimed in Claim 2, wherein the operating temperature of the actuator is within the range 100°C to 150°C

4. The piezoelectric actuator device (30) as claimed in Claim 1, wherein the material of the conductor members is one which has liquid behaviour at room temperature.

5. The piezoelectric actuator device (30) as claimed in any one of Claims 1 to 4, comprising a plurality of piezoelectric elements (42), wherein adjacent elements (42) share a common electrode (44a, 44b).

6. The piezoelectric actuator device (30) as claimed in any one of Claims 1 to 5, wherein the first and second channels (32, 34) are defined by apertures (33, 46, 48) provided in the piezoelectric elements (42) and the electrodes (44a, 44b).

7. The piezoelectric actuator device (30) as claimed in Claim 6, wherein the apertures (46, 48) of a first group of alternate ones of the electrodes (44a, 44b) are shaped so as to be in electrical contact with the positive conductor member (36a, 36b) and the apertures (46, 48) of a second group of remaining alternate ones of the electrodes (44a, 44b) are shaped so as to be in electrical contact with the negative conductor member (36a, 36b).

8. The piezoelectric actuator device (30) as claimed in Claim 6 or Claim 7, wherein ) the apertures (46, 48) of each electrode (44a, 44b) comprise a first aperture (48) having a larger area than that of the second aperture (46).

9. The piezoelectric actuator device (30) as claimed in any one of Claims 6 to 8, wherein the apertures (46, 48) are generally circular.

10. The piezoelectric actuator device (30) as claimed in any one of Claims 6 to 9, wherein the apertures (46, 48) are disposed on an axis of symmetry of a corresponding electrode (44a, 44b).

11. The piezoelectric actuator device (30) as claimed in any one of Claims 1 to 10, wherein the electrodes (44a, 44b) of each pair are planar and mutually parallel, and wherein the conductor members (36a, 36b) intersect the electrodes (44a, 44b) substantially perpendicular to the plane of the electrodes (44a, 44b).

12. A fuel injector having a piezoelectric device as claimed in any one of Claims 1 to 11.

## Patentansprüche

1. Piezoelektrische Stellgliedvorrichtung (30) mit einem Stapel (31) aus einem oder mehreren piezoelektrischen Elementen (42), die eine äußere Stapelgrenze bilden, und einem Mittel zum Aufbringen einer Spannung quer über das eine oder die mehreren piezoelektrischen Elemente (42), worin das Mittel umfasst:
ein Paar entgegengesetzt schaltbarer oder geschalteter Elektroden (44a, 44b);
einen ersten und einen zweiten Kanal (32, 34), die innerhalb der äußeren Stapelgrenze angeordnet sind;
ein positives und ein negatives Leiterelement (36a, 36b), die in dem ersten bzw. dem zweiten Kanal (32,34) aufgenommen sind;
**dadurch gekennzeichnet, dass** die Leiterelemente ein Material umfassen oder daraus bestehen, welches mindestens für eine Zeitdauer des Stellgliedbetriebs das Verhalten einer Flüssigkeit zeigt.

2. Piezoelektrische Stellgliedvorrichtung (30) wie in Anspruch 1 beansprucht, worin das Material der Leiterelemente ein solches ist, das im Gebrauch bei der Betriebstemperatur des Stellglieds flüssig wird.

3. Piezoelektrische Stellgliedvorrichtung (30) wie in Anspruch 2 beansprucht, worin die Betriebstemperatur des Stellglieds im Bereich von 100°C bis 150°C liegt.

4. Piezoelektrische Stellgliedvorrichtung (30) wie in Anspruch 1 beansprucht, worin das Material der Leiterelemente ein solches ist, das bei Raumtemperatur das Verhalten einer Flüssigkeit zeigt.

5. Piezoelektrische Stellgliedvorrichtung (30) wie in einem der Ansprüche 1 bis 4 beansprucht, umfassend eine Mehrzahl von piezoelektrischen Elementen (42), worin benachbarte Elemente (42) eine gemeinsame Elektrode (44a,44b) teilen.

6. Piezoelektrische Stellgliedvorrichtung (30) wie in einem der Ansprüche 1 bis 5 beansprucht, worin der erste und der zweite Kanal (32,34) von Öffnungen (33,46,48) gebildet bzw. begrenzt werden, die in den piezoelektrischen Elementen (42) und den Elektroden (44a,44b) vorhanden sind.

7. Piezoelektrische Stellgliedvorrichtung (30) wie in Anspruch 6 beansprucht, worin die Öffnungen (46,48) einer ersten Gruppe alternierender Elektroden (44a,44b) so gestaltet sind, dass sie sich in elektrischem Kontakt mit dem positiven Leiterelement (36a,36b) befinden, und die Öffnungen (46,48) einer zweiten Gruppe von restlichen alternierenden Elektroden (44a,44b) so gestaltet sind, dass sie sich in elektrischem Kontakt mit dem negativen Leiterelement (36a,36b) befinden.

8. Piezoelektrische Stellgliedvorrichtung (30) wie in Anspruch 6 oder Anspruch 7 beansprucht, worin die Öffnungen (46,48) jeder Elektrode (44a,44b) eine erste Öffnung (48) umfassen, die einen größeren Querschnittsbereich als denjenigen der zweiten Öffnung (46) besitzt.

9. Piezoelektrische Stellgliedvorrichtung (30) wie in einem der Ansprüche 6 bis 8 beansprucht, worin die Öffnungen (46,48) allgemein kreisförmig sind.

10. Piezoelektrische Stellgliedvorrichtung (30) wie in einem der Ansprüche 6 bis 9 beansprucht, wobei die Öffnungen (46,48) auf einer Symmetrieachse einer entsprechenden Elektrode (44a,44b) angeordnet sind.

11. Piezoelektrische Stellgliedvorrichtung (30) wie in einem der Ansprüche 1 bis 10 zueinander sind und worin die Leiterelemente (36a,36b) die Elektroden (44a,44b) im wesentlichen rechtwinklig zu der Ebene der Elektroden (44a,44b) schneiden.

12. Kraftstoffeinspritzventil mit einer piezoelektrischen Vorrichtung wie in einem der Ansprüche 1 bis 11 beansprucht.

## Revendications

1. Dispositif d'actionneur piézo-électrique (30) incluant un empilement (31) d'un ou plusieurs éléments piézo-électriques (42) définissant une limite d'empilement externe et des moyens permettant d'appliquer une tension au travers des un ou plusieurs éléments piézo-électriques (42), dans lequel les moyens incluent :
une paire d'électrodes opposées (44a, 44b) ;
des premier et deuxième canaux (32, 34) disposés à l'intérieur de la limite d'empilement externe ;
des éléments conducteurs positif et négatif (36a, 36b) reçus par lesdits premier et deuxième canaux (32, 34) respectivement ;
**caractérisé en ce que** les éléments conducteurs comprennent un matériau qui a un comportement liquide pendant au moins une période de fonctionnement de l'actionneur.

2. Dispositif d'actionneur piézo-électrique (30) selon la revendication 1, dans lequel le matériau des éléments conducteurs est un matériau qui devient liquide à la température de fonctionnement de l'actionneur, lors de l'utilisation.

3. Dispositif d'actionneur piézo-électrique (30) selon la revendication 2, dans lequel la température de fonctionnement de l'actionneur se trouve dans la plage comprise entre 100°C et 150°C.

4. Dispositif d'actionneur piézo-électrique (30) selon la revendication 1, dans lequel le matériau des éléments conducteurs est un matériau qui présente un comportement liquide à température ambiante.

5. Dispositif d'actionneur piézo-électrique (30) selon l'une quelconque des revendications 1 à 4, comprenant une pluralité d'éléments piézo-électriques (42), dans lequel les éléments adjacents (42) partagent une électrode commune (44a, 44b).

6. Dispositif d'actionneur piézo-électrique (30) selon l'une quelconque des revendications 1 à 5, dans lequel les premier et deuxième canaux (32, 34) sont définis par des ouvertures (33, 46, 48) ménagées dans les éléments piézo-électriques (42) et électrodes (44a, 44b).

7. Dispositif d'actionneur piézo-électrique (30) selon la revendication 6, dans lequel les ouvertures (46, 48) d'un premier groupe d'autres électrodes des électrodes (44a, 44b) sont formées de manière à être en contact électrique avec l'élément conducteur positif (36a, 36b) et les ouvertures (46, 48) d'un deuxième groupe d'autres électrodes restantes des électrodes (44a, 44b) sont formées de manière à être en contact électrique avec l'élément conducteur négatif (36a, 36b).

8. Dispositif d'actionneur piézo-électrique (30) selon la revendication 6 ou la revendication 7, dans lequel les ouvertures (46, 48) de chaque électrode (44a, 44b) comprennent une première ouverture (48) ayant une surface supérieure à celle de la deuxième ouverture (46).

9. Dispositif d'actionneur piézo-électrique (30) selon l'une quelconque des revendications 6 à 8, dans lequel les ouvertures (46, 48) sont généralement circulaires.

10. Dispositif d'actionneur piézo-électrique (30) selon l'une quelconque des revendications 6 à 9, dans lequel les ouvertures (46, 48) sont disposées sur un axe de symétrie d'une électrode correspondante (44a, 44b).

11. Dispositif d'actionneur piézo-électrique (30) selon l'une quelconque des revendications 1 à 10, dans lequel les électrodes (44a, 44b) de chaque paire sont planes et mutuellement parallèles, et dans lequel les éléments conducteurs (36a, 36b) coupent les électrodes (44a, 44b) sensiblement perpendiculairement au plan des électrodes (44a, 44b).

12. Injecteur de carburant comportant un dispositif piézo-électrique selon l'une quelconque des revendications 1 à 11.
